Europäisches Patentamt

European Patent Office

Office européen des brevets

(19)

(11) Publication number : **0 366 552 B1**

(12) **EUROPEAN PATENT SPECIFICATION**

(45) Date of publication of patent specification :
28.04.93 Bulletin 93/17

(51) Int. Cl.⁵ : **H01L 29/73, H01L 21/331, H01L 21/22, H01L 29/201**

(21) Application number : 89402953.7

(22) Date of filing : 25.10.89

(54) Method of manufacturing a heterojunction bipolar transistor.

(30) Priority : 27.10.88 JP 271345/88

(43) Date of publication of application :
02.05.90 Bulletin 90/18

(45) Publication of the grant of the patent :
28.04.93 Bulletin 93/17

(84) Designated Contracting States :
DE FR GB

(56) References cited :
IEEE ELECTRON DEVICE LETTERS, vol.
EDL-8, no. 9, September 1987, pages 383-385,
New York, US; K.C. WANG et al.: "A 20-GHz
frequency divider implemented with hetero-
junction bipolar transistors"
JAPANESE JOURNAL OF APPLIED PHYSICS,
vol. 25, no. 10, part 2, October 1986, pages
L862-L864, Tokyo, JP; A. FURUKAWA et al.:
"4.2 K operation of InAlAs/InGaAs heterojunc-
tion bipolar transistor"

(56) References cited :
INTERNATIONAL ELECTRON DEVICES MEET-
ING, TECHNICAL DIGEST, Los Angeles, CA,
7th - 10th December 1986, pages 89-92, IEEE,
New York, US; K. OHTA et al.: "Theory and
experiment of heterojuncion bipolar transistor
at very low temperatures"
APPLIED PHYSICS LETTERS, vol. 53, no 11,
12th September 1988, pages 983-985, Ameri-
can Institute of Physics, New York, US; W.T.
TSANG et al.: "GaInAs/GaInAsP/InP heteros-
tructure bipolar transistors with very thin base
(150 A) grown by chemical beam epitaxy"
Journal of Crystal Growth 46(1979) 300-303.
Appl. Phys. Lett. 37(1) 1July 1980 p.64-65.

(73) Proprietor : FUJITSU LIMITED
1015, Kamikodanaka Nakahara-ku
Kawasaki-shi Kanagawa 211 (JP)

(72) Inventor : Ishikawa, Hideaki
1328-1-001, Tsurumaki
Hadano-shi Kanagawa 257 (JP)
Inventor : Fujii, Toshio
1-21-9, Morinosato
Atsugi-shi Kanagawa 243-01 (JP)
Inventor : Miyauchi, Eizo
4-1-15-103, Kirigaoka Midori-ku
Yokohama-shi Kanagawa 227 (JP)

(74) Representative : Joly, Jean-Jacques et al
Cabinet Beau de Loménie 158, rue de
l'Université
F-75340 Paris Cédex 07 (FR)

EP 0 366 552 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Jouve, 18, rue Saint-Denis, 75001 PARIS

## Description

## BACKGROUND OF THE INVENTION

The present invention generally relates to semiconductor devices and more particularly to a method of manufacturing a heterojunction bipolar transistor (HBT).

HBT using a group III-V compound semiconductor material such as gallium arsenide (GaAs) is characterized by a high operational speed. This desirable operational characteristic is obtained mainly as a result of the high electron mobility in the the group III-V compound forming the transistor. Further the use of a material having a large band gap for the emitter also contributes to the increase of the speed of the device.

In such an HBT, or in a bipolar transistor in general, it is desired that the base of the transistor is made as thin as possible in order to reduce the base transit time of electron and hence to increase the operational speed of the transistor further. However, excessive reduction of the thickness of the base causes an adverse increase of the base spreading resistance which in turn decreases the speed of the transistor. Thus, in order to decrease the thickness of the base without increasing the base spreading resistance, it is desired to dope the base to a doping level as high as possible, for example to a level of about $1 \times 10^{20}$ cm$^{-3}$.

Meanwhile, it is known that the operational speed of the HBT is further improved by establishing an electric field in the base such that the electron passing therethrough is accelerated. Such an electric field is obtained by providing a compositional gradient in the material forming the base such that there is a large band gap at a side of the base in contact with the emitter and such that the band gap is narrowed continuously toward the collector. For this purpose, gallium aluminium arsenide (GaAlAs) having a composition of $Ga_{1-x}Al_xAs$ is used for the base with a gradual change of the composition $\underline{x}$ ranging from 0 to 0.1. Note that there is substantially no change of lattice constant in the foregoing system and the problem of the lattice mismatch is avoided.

In an npn-type HBT constructed on a GaAs substrate with a base of GaAs doped to the p-type, beryllium (Be) is used as the dopant for the base. Unfortunately, it is known that the diffusion coefficient of Be in GaAs increases steeply by a factor of one thousand to even ten thousand when the concentration level of Be is increased beyond a level of about $4 \times 10^{19}$ cm$^{-3}$ (Pao, Y.C. et al. J. Appl. Phys. $\underline{60}$, 1986, p.201). Further, it is known that such an increase of the diffusion coefficient of Be is further enhanced in the system of GaAlAs (Miller, D.L., J. Appl. Phys. $\underline{57}$, 1985, p. 1816). In other words, there is a tendency that Be is diffused into the neighbouring collector and emitter during the manufacturing process of the transistor, and there is a substantial risk that the conduction type of the emitter and collector is changed or the bipolar structure of the transistor is damaged. As a high temperature of about 600 °C or more is needed for the growth of GaAlAs, the problem of diffusion of Be into the neighbouring collector or emitter becomes worse in the case of the HBT using GaAlAs for the graded base. Thus, the conventional HBT has a problem in that it cannot be constructed to have a sufficiently reduced base thickness as well as a graded base profile to fully exploit the high speed performance of the HBT.

A similar problem appears also when the npn-type HBT is constructed on an indium phosphide (InP) substrate with a base of indium gallium aluminium arsenide (InGaAlAs) sandwiched by a collector and an emitter of indium gallium arsenide. Thus, when Be is doped to a level exceeding about $1 \times 10^{20}$ cm$^{-3}$ in InGaAlAs, the diffusion coefficient of Be is increased significantly.

On the other hand, there is a known HBT described by Wang et al. (Wang, K.C., Asbeck, P.M., Chang, M.F., Sullivan, G.J. and Miller, D.L., IEEE Electron Device Letters, EDL-8, no.9, September 1987, pp.383 - 385) in which Be is doped to the base with a high concentration level together with an indium arsenide (InAs) component contained in the base by an amount of 10 mole %. In this device, the problem of excessive diffusion of Be is avoided by choosing InGaAs which is free from aluminium (Al) for the base so that the base can be grown in a low temperature range of about 500°C or less. This device, however, does not allow the compositional gradient in the base and thus the device has a limitation in the operational speed. Formation of the compositional gradation by adding elements other than Al to the system of InGaAs is generally not possible because of the unacceptable mismatch of lattice with respect to the collector or emitter.

## SUMMARY OF THE INVENTION

Accordingly, it is a general object of the present invention to provide a novel and useful method of manufacturing a heterojunction bipolar transistor wherein the aforementioned problems are eliminated.

Another and more specific object of the present invention is to provide a method of manufacturing a semiconductor device having an epitaxial layer of a compound semiconductor material containing Be with a high concentration level, wherein the abnormal increase of the diffusion of Be in the epitaxial layer can be suppressed effectively.

EP 0 366 552 B1

Another object of the present invention is to provide a method of manufacturing a semiconductor device having an epitaxial layer of a p-type compound semiconductor material selected from a group comprising GaAlAs and indium gallium aluminium arsenide (InGaAlAs), with a composition adjusted so as to achieve a lattice matching with an underlying crystal and doped by Be with a concentration level of $5 \times 10^{19} - 5 \times 10^{20} cm^{-3}$, wherein the epitaxial layer is further added with indium (In) with a level of 0.5 - 8 mole % with respect to the group III elements contained in the epitaxial layer. According to the present invention, the strain induced in the crystal structure of the group III-V compound semiconductor material by the doping of Be having a small atomic radius (1.06 Å) (1Å = $10^{-10}$m) is compensated by addition of In which has a large atomic radius (1.44 Å). As a result, energetical instability of Be associated with the strain energy of the lattice deformation which in turn invites relative lowering of the energy barrier of diffusion is eliminated and the problem of the abnormal increase of the diffusion of Be is avoided. Note that Be and In are distributed at random in the crystallographic site for the group III element in the structure and the overall strain of the crystal lattice is relaxed. As a result of elimination of the abnormal diffusion of Be, the semiconductor device such as HBT can be manufactured without the risk that the semiconductor layers adjacent to the foregoing epitaxial layer are erroneously doped or the structure of the device is destroyed.

Other objects and further features of the present invention will be apparent from the following detailed description when read in conjunction with attached drawings.

BRIEF DESCRIPTION OF THE DRAWINGS

FIGS.1(A) and (B) are schematical diagrams showing the principle of the present invention;

FIGS.2(A) and (B) are diagrams showing samples used for experiments conducted to demonstrate the suppressing of the diffusion of Be by doping of In;

FIGS.3(A) and (B) are diagrams showing results of the experiment using the sample of FIG.2(A) corresponding to a prior art;

FIGS.4(A) - (C) are diagrams showing results of the experiment using the sample of FIG.2(B) corresponding to the present invention;

FIG.5 is a graph showing the result of the experiment for the sample of FIG.2(B) in correspondence to the present invention while changing the In content;

FIG.6 is a cross sectional view showing a structure of an HBT manufactured according to a first embodiment of the present invention;

FIG.7 is a diagram showing a compositional profile of aluminium in the device of FIG.6; and

FIG.8 is a cross sectional view showing a structure of an HBT manufactured according to a second embodiment of the present invention.

DETAILED DESCRIPTION

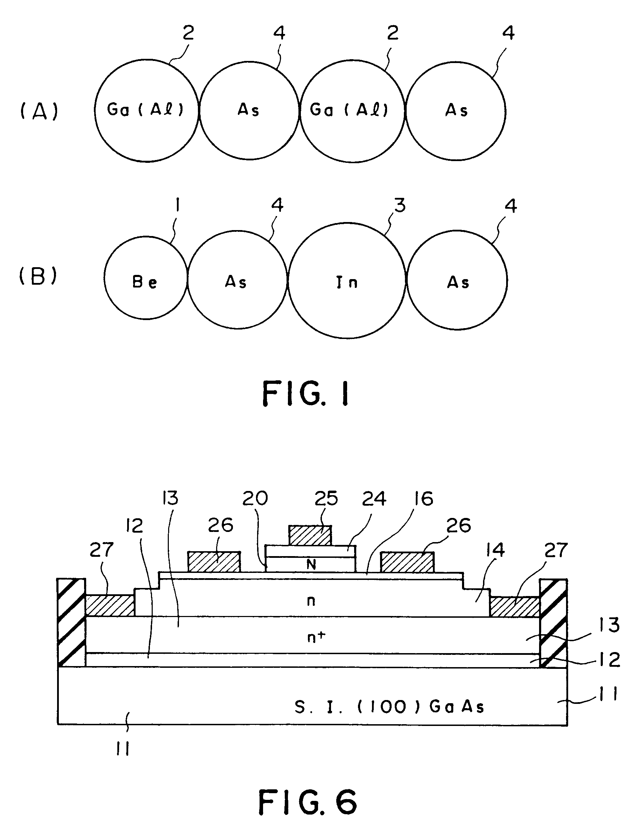

FIGS.1(A) and (B) show the principle of the present invention. In FIG.1(A) showing a schematical structure of GaAs, a gallium (Ga) atom 2 and an As atom 4 are assembled into a zinc blende structure having a face-centered cubic (fcc) packing in which the Ga atom 2 occupies a sublattice or site for the group III element having the tetrahedral coordination and the As atom 4 occupies a sublattice or site for the group V element also having the tetrahedral coordination. In a GaAlAs crystal, Al substitutes a part of Ga.

When a Be atom 1 is doped with a substantial concentration to the structure of FIG.1(A), the Be atom thus doped substitutes a part of the Ga atoms 2 as shown in FIG.1(B). Thereby, there appears a distortion or deformation in the crystal structure particularly when the concentration level of Be is increased to a range of about $5 \times 10^{19} - 5 \times 10^{20} cm^{-3}$, as the Be atom has a substantially smaller atomic radius as compared to Ga atom or Al atom.

The following Table I summarizes the atomic radius for Be and the group III as well as group V elements involved in the HBT of the present invention.

3

## TABLE I

## Atomic radius of typical group III and group V elements
## as well as Be used for doping of group III-V compound.

| | |
|---|---|
| Be | 1.06 Å |
| Al | 1.26 Å |
| Ga | 1.26 Å |
| In | 1.44 Å |
| As | 1.18 Å |

In the present invention, it was found that the abnormal increase of the diffusion of Be in the compound or system of GaAlAs or InGaAlAs is suppressed significantly by introducing In with an amount of about 0.5 to 8 mole % with respect to the group III elements in the system. As a result of simultaneous addition of an In atom 3 together with the Be atom 1, the strain formed in the crystal structure is relaxed as shown in FIG.1(B). It is believed that such a relaxation of the strain of the crystal structure causes the relative lowering of the energy of Be in the structure and the energy barrier for diffusion of Be is relatively increased as compared to the potential energy of Be. As a result of such a relative increase of the energy barrier of diffusion, the abnormal diffusion of Be into the neighbouring semiconductor layers is successfully eliminated.

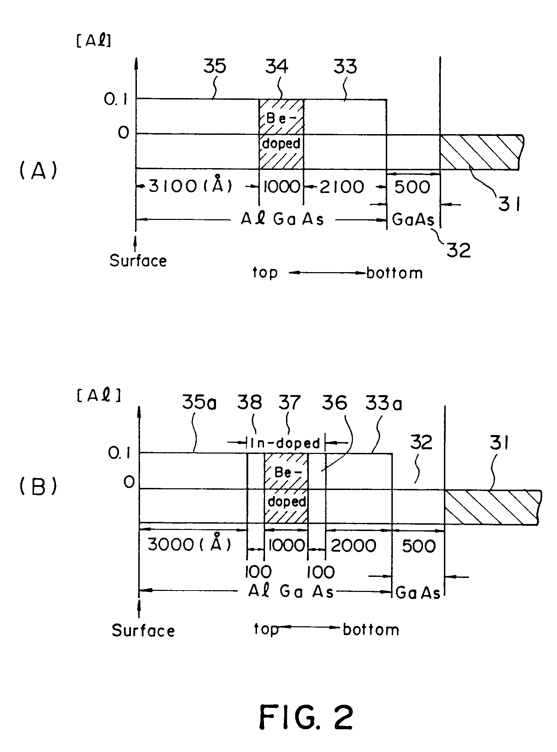

FIGS.2(A) and (B) show the construction of test samples used to demonstrate the effect of eliminating the abnormal diffusion of Be by simultaneous addition of In according to the present invention in comparison with a prior art method in which no such simultaneous addition of In is made.

Referring to FIG.2(A) showing a test sample produced according to the prior art method, a buffer layer 32 of GaAs is grown epitaxially on a (100) surface of a GaAs substrate 31 for a thickness of 500 Å and an GaAlAs layer 33 having a composition of $Ga_{0.9}Al_{0.1}As$ is grown further on the buffer layer 32 for a thickness of 2100 Å. On the GaAlAs layer 33, another GaAlAs layer 34 doped to the p-type and having the same composition $Ga_{0.9}Al_{0.1}As$ is grown for a thickness of 1000 Å. In this test sample, the thickness of the layer 34 is set larger than the actual thickness of the base of a typical HBT in order to examine the diffusion of Be in detail. Further, another GaAlAs layer 35 having also the same composition $Ga_{0.9}Al_{0.1}As$ is grown on the layer 34. In the drawing, the ordinate represents the composition of aluminium (Al) in the layers 31 - 35.

FIG.2(B) shows the structure of a test sample corresponding to the present invention. In this drawing, these portions corresponding to the portions described with reference to FIG.2(A) are given the identical reference numerals and the description thereof will be omitted.

In this test sample, after the epitaxial growth of the buffer layer 32 for a thickness of 500 Å on the substrate 31, a GaAlAs layer 33a having a composition of $Ga_{0.9}Al_{0.1}As$ is grown on the buffer layer 32 for a thickness of 2000 Å. Next, a lower boundary layer 36 having a composition of $Ga_{0.9}Al_{0.1}As$ and added with In is grown on the buffer layer 33a for a thickness of 100 Å, and a p-type GaAlAs layer 37 is grown on the lower boundary layer 36 together with the addition of In and further with Be for a thickness of 1000 Å. Further, an upper boundary layer 38 of GaAlAs having a composition of $Ga_{0.9}Al_{0.1}As$ and added with In is grown on the p-type layer 37 with a thickness of 100 Å. Further, a still another GaAlAs layer 35a having the same composition of $Ga_{0.9}Al_{0.1}As$ is grown with a thickness of 3000 Å. The In concentration with respect to the total amount of Ga and Al is maintained the same throughout the layers 36 - 38. Further, a number of test samples having the structure of FIG.2(B) are prepared with various concentration levels for In. Note that the ordinate in FIG.2(B) represents the Al composition similarly to the case of FIG.2(A).

In both of the test samples, the growth of the layers is made by molecular beam epitaxy (MBE) at a temperature of 600°C with a growth rate of 1 μm/hour. During the growth, the vapor pressure of As is controlled at $4 \times 10^{-5}$ Torr, and the temperature of the cells for holding the source materials of Al and Ga is controlled such that the composition ratio of Al and Ga in the obtained semiconductor layer is maintained at 1 : 9. Further, the temperature of the cells for holding the source material of Be and In is controlled so as to establish a predetermined concentration level for these elements. As a result, Be alone or Be and In together are incorporated into the crystallographic site for the group III element of GaAlAs during the growth of the layer 37.

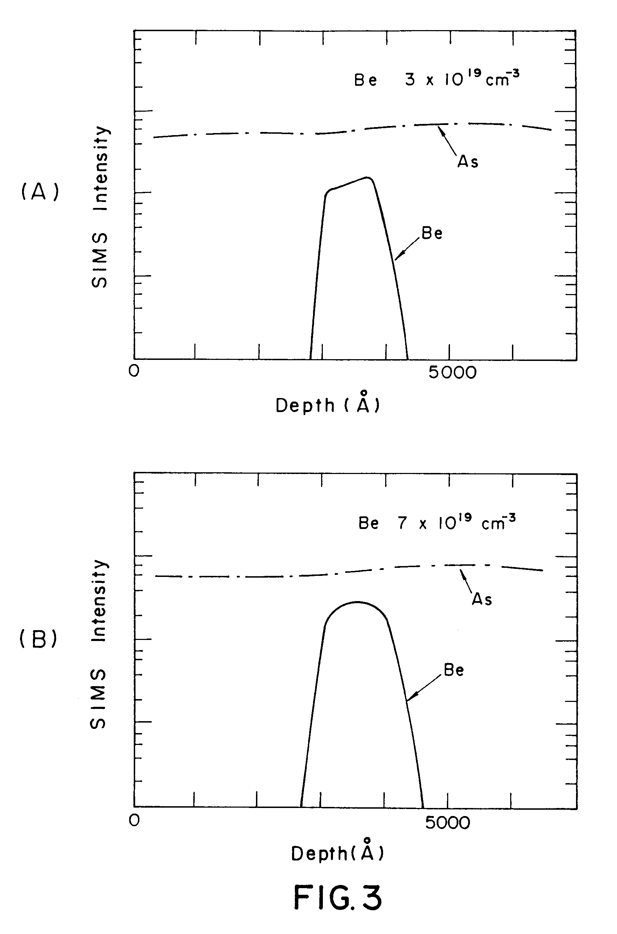

FIGS.3(A) and (B) show the result of evaluation of the test samples of FIG.2(A) thus formed. In this evaluation, the compositional profile of Be was measured from the top surface of the GaAlAs layer 35 to the bottom of the GaAlAs layer 33 by secondary ion mass spectroscopy (SIMS), in which FIG.3(A) shows the case in which Be is doped to the layer 34 with a level of $3 \times 10^{19}$ cm$^{-3}$ and FIG.3(B) shows the case in which Be is doped to the layer 34 with a level of $7 \times 10^{19}$ cm$^{-3}$. In the description hereinafter, the thickness of a region which contains Be is represented as a thickness of a layer containing Be with a concentration level which is one-tenth of the maximum concentration level of Be contained in that region.

As is clearly seen from FIG.3(A), the region of the sample in which Be is contained is confined within a thickness of about 1200 Å in correspondence to the designed layer thickness of the layer 34 when Be is doped within the level of $3 \times 10^{19}$ cm$^{-3}$. No substantial diffusion of Be beyond the base layer 34 is observed. On the other hand, when the concentration level of Be is increased to a level of $7 \times 10^{19}$ cm$^{-3}$, the thickness of the region in the sample in which Be is contained is broadened to a thickness of about 1500 Å as is clearly seen in FIG.3(B). This means that there is a substantial diffusion of Be from the base layer 34 in agreement with the aforementioned report (Pao, Y.C. et al. op.cit.).

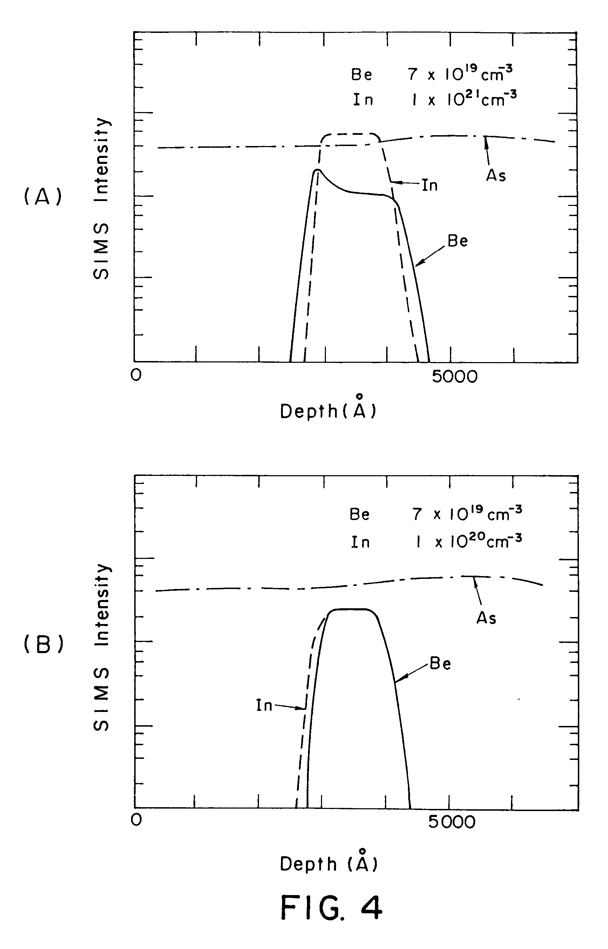

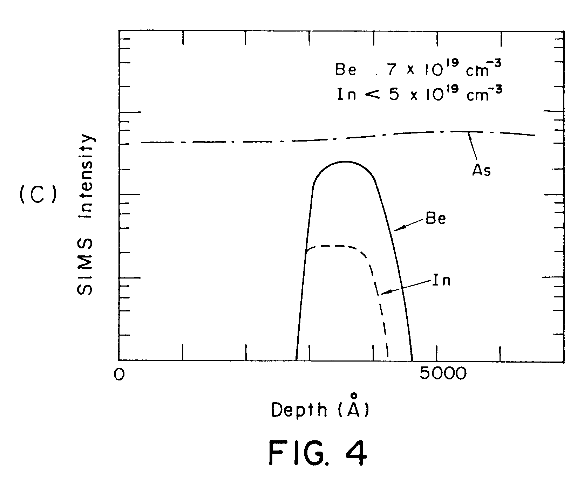

FIGS.4(A), (B) and (C) show a result of the evaluation for the test sample of FIG.2(B) with a constant doping level of Be at $7 \times 10^{19}$ cm$^{-3}$ and with various In concentration levels. The evaluation was made by SIMS similarly to the foregoing case.

Referring to FIG.4(A) corresponding to the Be concentration level of $7 \times 10^{19}$ cm$^{-3}$ and the In concentration level of $1 \times 10^{21}$ cm$^{-3}$, there appears a similar broadening of the Be-containing region reaching a thickness of about 1800 Å similarly to the case of FIG.3(B). In other words, there exists a similar abnormal increase of Be diffusion in this case.

When the In concentration level is reduced to $1 \times 10^{19}$ cm$^{-3}$ (FIG.4(B)), on the other hand, it can be seen that the thickness of the portion containing Be in the test sample is confined in the range of about 1200 Å even when the layer 37 is doped with Be to the concentration level of $7 \times 10^{19}$ cm$^{-3}$. In other words, the abnormal increase of the diffusion of Be is effectively suppressed when the In content in the GaAlAs layer 37 is chosen as such.

When the content or concentration level of In is further reduced to below $5 \times 10^{19}$ cm$^{-3}$ which is the detection limit of SIMS, it can be seen from FIG.4(C) that the broadening of the Be-containing region is again increased to an extent of about 1500 Å similarly to that of FIG.3(B). In this case, it is understood that the suppression of the abnormal diffusion of Be is not effective because of the too small concentration level of In.

Note that a similar tendency is observed also in the system of GaAs, InGaAs or InGaAlAs. In general, it was found that the abnormal increase of the diffusion coefficient of Be is suppressed by adding In according to a formula of $In_y(III)_{1-y}(V)$ simultaneously to the doping of Be where (III) represents the group III elements, (V) represents the group V elements, and y = 0 represents the hypothetical composition in which there is no doping of Be. The composition $\underline{y}$ is determined generally proportional to the amount of Be added for the doping. By adding In as such, the ratio between two or more group III elements, which is usually determined to achieve a lattice matching with adjacent layers, is maintained. For example, In is added to $Ga_{1-x}Al_xAs$ such that the composition after the addition of In is represented as $In_y(Ga_{1-x}Al_x)_{1-y}As$. Obviously, the ratio between Al and Ga is not changed by the addition of In. When In is added to a system already including In such as $In_xGa_{1-x}As$, the composition after the addition of In is represented as $In_y(In_xGa_{1-x})_{1-y}As$. The value $\underline{y}$ is determined by the concentration level of Be to be added for doping as already described. In the case that Be is doped to the level of $5 \times 10^{19} - 5 \times 10^{20}$ cm$^{-3}$, a range of $\underline{y}$ between 0.005 to 0.08 is preferred for eliminating the unwanted abnormal increase of diffusion of Be.

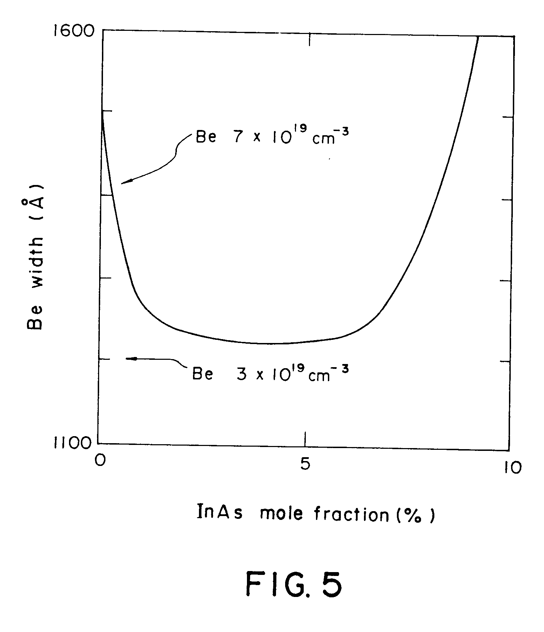

FIG.5 shows the thickness of the Be-containing region formed in the test sample of FIG.2(B) for various In concentration levels. Similarly to the foregoing experiments, the concentration of Be is fixed at $7 \times 10^{19}$ cm$^{-3}$. As is clearly seen in this drawing, there is a minimum in the thickness of the Be-containing region in correspondence to the compositional range of about 0.5 mole % to about 8 mole % represented in terms of the InAs component.

The foregoing results clearly indicate that the abnormal diffusion of Be is suppressed by simultaneous addition of In to the system. The reason for this is attributed to the aforementioned compensation of the strain of the crystal lattice induced by Be by the further addition of In. As a result of the relaxation of the lattice strain, it is believed that Be is stabilized energetically as compared to the energy barrier for the diffusion of Be. According to this theory, it is predicted that there holds a relation:

$$(v_{Ga} - v_{Be})N_{Be} = (v_{In} - v_{Ga})N_{In}$$

where $v_{Ga}$, $v_{Be}$, $v_{In}$ respectively stand for the atomic volume of Ga, Be and In, and $N_{Be}$ and $N_{IN}$ stand for the number of atoms of Be and In, respectively. In this case, a relation $N_{In} = 0.8 \times N_{Be}$ is predicted. In other words, it is predicted that a simultaneous doping of In with an amount which is approximately the same as that of Be is effective for the suppressing of the abnormal diffusion of Be. The results shown in FIGS.4(A) - (C) and FIG.5 supports this prediction. Thus, when the concentration level of In is too small as in the case of FIG.4(C), the abnormal diffusion of Be is not suppressed effectively because of the remaining strain in the crystal lattice. On the other hand, when the concentration of In is too high as in the case of FIG.4(A), there is induced a strain in the crystal lattice as a result of the too high concentration of In. The reason of the appearance of the optimum range of In for a given Be concentration level as shown in FIG.5 is thus explained reasonably according to the foregoing theory. It would be obvious that the suppressing of the abnormal diffusion of Be by the simultaneous doping of In is not limited to the system of GaAlAs but is applicable also to other systems.

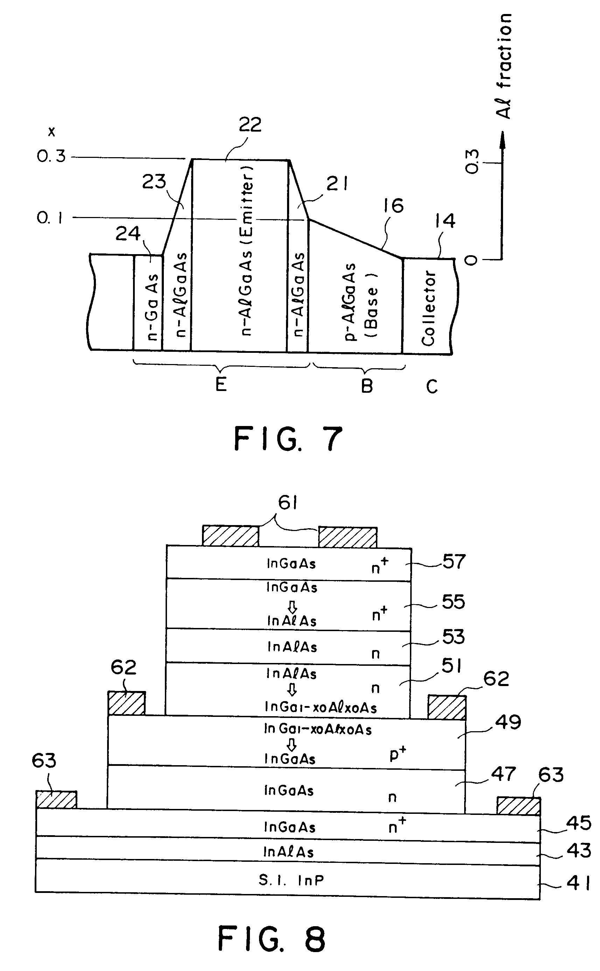

Next, an HBT manufactured according to the present invention will be described. FIG.6 shows a structure of an HBT according to an embodiment of the present invention. In this device, an $n^+$-type collector buffer layer of GaAs 13 and an n-type collector 14 of GaAs are grown consecutively on a buffer layer 12 of GaAs which in turn is grown on an (100) surface of a semi-insulating GaAs substrate 11. The collector buffer layer 13 has a thickness of 5000 Å and a donor concentration level of $3 \times 10^{18}$ cm$^{-3}$ while the collector layer 14 has a thickness of 3000 Å and a donor concentration level of $5 \times 10^{16}$ cm$^{-3}$.

On the collector layer 14 of GaAs, a p+-type base layer 16 of InGaAlAs doped with Be and having a composition adjusted so as to maintain the lattice matching with the underlying collector layer 14, is grown epitaxially for a thickness of about 1000 Å, for example, with a compositional gradient of Al as shown in FIG.7. Be is doped typically to a concentration level of about $1 \times 10^{20}$ cm$^{-3}$. Further, an n-type emitter layer 20 of GaAlAs and an $n^+$-type emitter cap layer 24 are grown epitaxially on the base layer 16 with the compositional gradient of Al as shown in FIG.7. Note that the base layer 16 ordinarily achieves the lattice matching with the collector layer 14 when it is free from In and Be. When Be is doped to a level of $5 \times 10^{19}$ - $5 \times 10^{20}$ cm$^{-3}$ in order to reduce the base spreading resistance, the lattice matching is lost because of the small atomic radius of Be incorporated into the base layer 16. In the present embodiment, the strain induced in the crystal lattice of the $p^+$-type InGaAlAs base layer 16 by the doping of Be is successfully eliminated by the simultaneous addition of In according to the formula $In_y(Ga_{1-x}Al_x)_{1-y}As$, in which the parameter y is set to the foregoing range of 0.005 - 0.08 and the foregoing lattice matching is reestablished. Note that the composition $\underline{x}$ for Al is changed with respect to the composition of Ga represented as 1 - x from a value 0.0 at an interface to the collector layer 14 to 0.1 at another interface to the emitter layer 20 independently of the composition $\underline{y}$. Thus, there is established an electrical field which accelerates the electron passing through the base layer 16 similarly to the case that there is no doping of In.

The n-type emitter layer 20 further comprises a first layer 21 having a thickness of about 300 Å and a donor concentration level of about $5 \times 10^{17}$ cm$^{-3}$ with the aluminium composition ranging from 0.1 to 0.3, a second layer 22 having a thickness of about 900 Å and the same donor concentration level with the aluminium composition of 0.3, and a third layer 23 having a thickness of about 300 Å and the same donor concentration level with the aluminium composition decreasing from 0.3 to zero as illustrated in FIG.7. As a result of the compositional gradient of Al as such, the band structure across the collector, base and emitter becomes continuous and the undesirable spike and notch in the band structure is eliminated.

The $n^+$-type cap layer 24 has a thickness of about 1500 Å and a donor concentration level of about $5 \times 10^{18}$ cm$^{-3}$. On this cap layer 24, an emitter electrode 25 is provided. Similarly, a base electrode 26 is provided on the base layer 16 and a collector electrode 27 is provided on the collector buffer layer 13.

The growth of the layers 12 - 24, particularly the base layer 16, is preferrably made according to the MBE process already described with reference to the formation of the test sample of FIG.2(B) or MOCVD in which a near-ideal stoichiometry is maintained in the group III-V compound semiconductor layers thus grown. The epitaxial growth of the layers 16 and 20 containing Al can be made in the temperature rang of 550 - 680 °C, preferably above 600°C. By adding In to the base layer 16 together with Be, the diffusion of Be to the neighbouring emitter layer 20 or collector layer 14 is effectively prevented even the layers 16 and 20 are grown in such a relatively high temperature range and the destruction of the HBT structure is avoided while still maintaining the graded compositional structure which facilitates the high speed operation of the device.

Next, a second embodiment of the HBT will be described with reference to FIG.8. In this embodiment, the HBT is constructed on a semi-insulating InP substrate 41. Referring to FIG.8, a buffer layer 43 of undoped InAlAs is grown epitaxially on the substrate 41 for a thickness of about 3000 Å while maintaining the lattice matching with the underlying substrate 41, and an $n^+$-type collector contact layer 45 of InGaAs with a donor concentration level of $2 \times 10^{19}$ cm$^{-3}$ is grown on the buffer layer 43 for a thickness of 5000 Å. Further, an n-type collector layer 47 of InGaAs with a donor concentration level of $3 \times 10^{16}$ cm$^{-3}$ is grown epitaxially on the collector contact layer 45 for a thickness of 5000 Å. The composition of the InGaAs layers 45 and 47 is adjusted to $In_{0.53}Ga_{0.47}As$ and the composition of the InAlAs buffer layer is adjusted to $In_{0.52}Al_{0.48}As$ in order to achieve the lattice matching with the underlying InP substrate 41. On a collector structure thus formed, a base layer 49 of InGaAlAs is grown epitaxially for a thickness of about 1000 Å. The base layer 49 is doped to the p-type by addition of Be to the concentration level of about $1 \times 10^{20}$ cm$^{-3}$. Note that the composition of the base layer 49 is graded such that the concentration of Al is increased gradually from 0 to 0.2 from a bottom boundary of the base layer 49 to a top boundary thereof. At the same time to the doping of the base layer 49 by Be, the concentration of In is increased from 0.53 to a level corresponding to the concentration of Be according to the foregoing relation. When the Be concentration level is set in the range of $5 \times 10^{19}$ - $5 \times 10^{20}$ cm$^{-3}$, In is added according to the formula $In_y[In_{0.53}(Ga_{1-x}Al_x)_{0.47}]_{1-y}As$ with the parameter $\underline{y}$ set in the range of 0.008 - 0.05. As a result of the foregoing compositional grading of Al, the parameter $\underline{x}$ changes from 0 to 0.2.

On the base layer 49, a first emitter layer 51 of InGaAlAs of the n-type and having a composition of $In_{0.53}(Ga_{1-x}Al_x)_{0.47}As$ is grown with the parameter $\underline{x}$ changing from 0.2 to 1 from the bottom to the top, and a second emitter layer 53 of InAlAs doped to the n-type is grown further thereon. The first emitter layer 51 has a thickness of about 300 Å and the second emitter layer 53 has a thickness of about 2000 Å. In both of the first and second emitter layers 51 and 53, the concentration level of the donor is fixed at about $2 \times 10^{17}$ cm$^{-3}$.

Further, a first cap layer 55 of InGaAlAs doped to the n-type with the donor concentration level of about $2 \times 10^{19}$ cm$^{-3}$ is grown on the second emitter layer 53 for a thickness of about 700 Å while changing the composition from one hundred percent InAlAs at the bottom to one hundred percent InGaAs at the top. Furthermore, a second cap layer 57 of InGaAs is grown on the first cap layer 55 for a thickness of about 500 Å. The second cap layer 57 is doped to a donor concentration level of about $1 \times 10^{19}$ cm$^{-3}$. As a result of the compositional gradation for the emitter layers 51 and 53 and for the cap layers 55 and 57, the undesirable spikes and notches are eliminated from the band structure. Finally, an emitter electrode 61 of gold-germanium alloy, a base electrode 62 of gold-zinc alloy, and a collector electrode 63 of gold-germanium alloy are provided respectively on the emitter cap layer 57, the base layer 49 and on the collector contact layer 45 and the HBT of this embodiment is completed.

Similarly to the foregoing embodiment, the growth of the layers 45 through 57 is made by MBE or MOCVD at a temperature of about 600°C or more. Because of the simultaneous doping of Be and In to the base layer 49, the diffusion of Be to the adjacent layers is successfully suppressed in spite of the high temperature employed for the growth of the base layer. Thus, an extremely high speed HBT having the operational speed enhanced by the use of thin but low resistance base layer as well as by the use of the graded compositional profile for the base and the emitter is obtained. Associated with the suppressing of the abnormal diffusion of Be, the reproducibility of the obtained HBT is improved.


## Claims

1. A method of manufacturing a semiconductor device comprising an epitaxial layer (16, 37, 49) of a group III-V semiconductor material provided on an underlying crystal layer (11 - 14, 31 - 36, 41 - 47) with a lattice matching therewith, said semiconductor material being doped to the p-type by addition of beryllium and selected from a group comprising gallium aluminium arsenide and indium gallium aluminium arsenide, comprising a step of growing said epitaxial layer on the underlying crystal layer, characterized by further steps of adding beryllium to a concentration level of about $5 \times 10^{19}$ atoms/cm$^3$ to about $5 \times 10^{20}$ atoms/cm$^3$ to the semiconductor material and adding indium by an amount of about 0.5 mole percent to about 8 mole percent with respect to group III elements in said semiconductor material.

2. A method as claimed in claim 1 characterized in that said step of adding beryllium and said step of adding indium are carried out during said step of growing the epitaxial layer (16, 37, 49).

3. A method as claimed in claim 2 characterized in that said step of adding beryllium and said step of adding indium are carried out simultaneously.

4. A method as claimed in claim 1 characterized in that said step of growing the epitaxial layer (16, 37, 49) is made at a temperature between about 550°C to about 680°C.

5. A method as claimed in claim 4 characterized in that said step of growing the epitaxial layer (16, 37, 49) is made at a temperature equal to or higher than about 600°C.

6. A method of manufacturing a bipolar transistor comprising steps of growing an n-type collector layer (14, 47) on an underlying crystal layer epitaxially (11 - 13, 41 - 45), growing a base layer (16, 49) of a group III-V compound semiconductor material selected from a group of materials comprising gallium aluminium arsenide and indium gallium aluminium arsenide on the n-type collector layer epitaxially, characterized in that the method comprises steps of doping the base layer to the p-type by adding beryllium to the base layer with a concentration level of about $5 \times 10^{19}$ atoms/cm$^3$ to about $5 \times 10^{20}$ atoms/cm$^3$, adding indium to the base layer by an amount of about 0.5 mole percent to about 8 mole percent with respect to group III elements contained in the base layer, and growing an n-type emitter layer (20, 51 - 55) on said base layer.

7. A method as claimed in claim 6 characterized in that said step of doping and said step of adding indium are carried out during said step of growing the base layer.

8. A method as claimed in claim 7 characterized in that said step of doping and said step of adding indium are carried out simultaneously.

9. A method as claimed in claim 6 characterized in that said growth of the base layer (16, 49) is made at a temperature in a range of about 550 °C to about 680°C.

10. A method as claimed in claim 6 characterized in that said growth of the base layer (16, 49) is made at a temperature of about 600°C or more.

11. A method as claimed in claim 6 characterized in that said step of growing the base layer (16, 49) further comprises a step of providing a gradation of aluminium content in the base layer such that the aluminium content is increased continuously from a first side of the base layer in contact with the collector layer (13, 47) to a second side of the base layer in contact with the emitter layer (20, 51 - 55).

12. A method as claimed in claim 6 characterized in that said step of growing the emitter layer further comprises a step of providing a compositional gradation of aluminium content in the emitter layer such that the aluminium content increases continuously, remains constant, and then decreases continuously from a first side of the emitter layer (20, 51 - 55) in contact with the base layer (16, 49) to a second side opposite from said first side.

13. A method of manufacturing a semiconductor device comprising an epitaxial layer (16, 37, 49) of a group III-V semiconductor material provided on an underlying crystal layer (11 - 14, 31 - 36, 41 - 47) with a lattice matching therewith, said semiconductor material being doped to the p-type by addition of beryllium and selected from a group comprising gallium aluminium arsenide and indium gallium aluminium arsenide, comprising a step of growing said epitaxial layer on the underlying crystal layer, characterized by further steps of adding beryllium to a predetermined concentration level, and adding indium by an amount generally equal to that of beryllium.

## Patentansprüche

1. Verfahren zur Herstellung einer- Halbleitereinrichtung, welche eine Epitaxialschicht (16, 37, 49) aus einem auf einer darunterliegenden Kristallschicht (11 - 14, 31 - 36, 41 - 47) mit einem dieser angepaßten Gitter geschaffenen Halbleitermaterial der Gruppe III-V umfaßt, wobei das genannte Halbleitermaterial durch Beigabe von Beryllium zum p-Typ dotiert und aus einer Gruppe ausgewählt wird, welche Gallium-Aluminium-Arsenid und Indium-Gallium-Aluminium-Arsenid enthält, umfassend eine Stufe des Aufwachsens der genannten Epitaxialschicht auf die darunterliegende Kristallschicht, **gekennzeichnet durch** weitere Stufen des Hinzufügens von Beryllium zu einem Konzentrationsgrad von etwa $5 \times 10^{19}$ Atomen/cm$^3$ bis etwa $5 \times 10^{20}$ Atomen/cm$^3$ zum Halbleitermaterial, und des Hinzufügens von Indium im Ausmaß von etwa 0,5 Mol-% bis etwa 8 Mol-% bezüglich der Elemente der Gruppe III im genannten Halbleitermaterial.

2. Verfahren nach Anspruch 1, **dadurch gekennzeichnet**, daß die Stufe der Beigabe von Beryllium und die Stufe der Beigabe von Indium während der Stufe des Aufwachsens der Epitaxialschicht (16, 37, 49) durchgeführt werden.

3. Verfahren nach Anspruch 2, **dadurch gekennzeichnet**, daß die Stufe des Hinzufügens von Beryllium und die Stufe des Hinzufügens von Indium gleichzeitig durchgeführt werden.

4. Verfahren nach Anspruch 1, **dadurch gekennzeichnet**, daß die Stufe des Aufwachsens der Epitaxialschicht (16, 37, 49) bei einer Temperatur zwischen etwa 550°C bis etwa 680°C erfolgt.

5. Verfahren nach Anspruch 4, **dadurch gekennzeichnet**, daß die Stufe des Aufwachsens der Epitaxialschicht (16, 37, 49) bei einer Temperatur erfolgt, welche gleich oder höher als etwa 600°C ist.

6. Verfahren zur Herstellung eines bipolaren Transistors, welches Stufen des epitaktischen Aufwachsens einer n-Typ-Kollektorschicht (14, 47) auf eine darunterliegende Kristallschicht (11 - 13, 41 - 45), des epitaktischen Aufwachsens einer Basisschicht (16, 49) eines III-V-Verbindungshalbleitermaterials, das aus einer Gruppe von Materialien, welche Gallium-Aluminium-Arsenid und Indium-Gallium-Aluminium-Arsenid enthalten, ausgewählt wurde, auf die n-typ-Kollektorschicht umfaßt, **dadurch gekennzeichnet**, daß das Verfahren Stufen des Dotierens der Basisschicht zum p-Typ durch Hinzufügen von Beryllium zur Basisschicht mit einem Konzentrationsgrad von etwa $5 \times 10^{19}$ Atomen/cm$^3$ bis etwa $5 \times 10^{20}$ Atomen/cm$^3$, des Hinzufügens von Indium zur Basisschicht mit einer Menge von etwa 0,5 Mol-% bis etwa 8 Mol-% bezüglich der in der Basisschicht enthaltenen Elemente der Gruppe III und des Aufwachsens einer n-typ-Emitterschicht (20, 51 - 55) auf die Basisschicht umfaßt.

7. Verfahren nach Anspruch 6, **dadurch gekennzeichnet**, daß die Stufe des Dotierens und die Stufe des Hinzufügens von Indium während der Stufe des Aufwachsens der Basisschicht ausgeführt werden.

8. Verfahren nach Anspruch 7, **dadurch gekennzeichnet**, daß die Stufe des Dotierens und die Stufe des Hinzufügens von Indium gleichzeitig ausgeführt werden.

9. Verfahren nach Anspruch 6, **dadurch gekennzeichnet**, daß das Aufwachsen der Basisschicht (16, 49) bei einer Temperatur im Bereich von etwa 550°C bis etwa 680°C erfolgt.

10. Verfahren nach Anspruch 6, **dadurch gekennzeichnet**, daß das Aufwachsen der Basisschicht (16, 49) bei einer Temperatur von etwa 600°C oder darüber erfolgt.

11. Verfahren nach Anspruch 6, **dadurch gekennzeichnet**, daß diese Stufe des Aufwachsens der Basisschicht (16, 49) weiters eine Stufe des Herstellens einer Gradation des Aluminiumgehalts in der Basisschicht so, daß der Aluminiumgehalt kontinuierlich von einer ersten mit der Kollektorschicht (13, 47) in Kontakt befindlichen Seite der Basisschicht zu einer zweiten mit der Emitterschicht (20, 51 - 55) in Kontakt befindlichen Seite der Basisschicht gesteigert wird, umfaßt.

12. Verfahren nach Anspruch 6, **dadurch gekennzeichnet**, daß die Stufe des Aufwachsens der Emitterschicht weiters eine Stufe des Herstellens einer Gradation in der Zusammensetzung des Aluminiumgehalts in der Emitterschicht, so daß der Aluminiumgehalt kontinuierlich ansteigt, konstant bleibt und dann von einer ersten mit der Basisschicht (16, 49) in Kontakt befindlichen Seite der Emitterschicht (20, 51 - 55) zu einer zweiten, gegenüber der ersten Seite liegenden Seite kontinuierlich abnimmt, umfaßt.

13. Verfahren zur Herstellung einer Halbleitereinrichtung, welche eine Epitaxialschicht (16, 37, 49) aus einem auf einer darunterliegenden Kristallschicht (11 - 14, 31 - 36, 41 - 47) mit einem dieser angepaßten Gitter geschaffenen Halbleitermaterial der Gruppe III-V umfaßt, wobei das genannte Halbleitermaterial durch die Beigabe von Beryllium zum p-Typ dotiert und aus einer Gruppe ausgewählt wird, welche Gallium-Aluminium-Arsenid und Indium-Gallium-Aluminium-Arsenid enthält, umfassend eine Stufe des Aufwachsens der genannten Epitaxialschicht auf die darunterliegende Kristallschicht, **gekennzeichnet durch** weitere Stufen der Beigabe von Beryllium zu einem vorbestimmten Konzentrationsgrad, und des Hinzufügens von Indium in einer im allgemeinen der Menge von Beryllium entsprechenden Menge.

## Revendications

1. Procédé de fabrication d'un dispositif à semiconducteur comprenant une couche épitaxiale (16, 37, 49) faite d'un matériau semiconducteur des groupes III-V qui est disposée sur une couche cristalline sous-jacente (11-14, 31-36, 41-47) en appariement de réseau avec celle-ci, ledit matériau semiconducteur étant dopé suivant le type p par addition de béryllium et étant choisi dans le groupe comprenant l'arséniure de gallium et d'aluminium et l'arséniure d'indium, de gallium et d'aluminium, comprenant l'opération qui consiste à faire croître ladite couche épitaxiale sur la couche cristalline sous-jacente, caractérisé par d'autres opérations, lesquelles consistent à ajouter au matériau semiconducteur du béryllium avec un niveau de concentration d'environ $5 \times 10^{19}$ atomes/cm$^3$ à environ $5 \times 10^{20}$ atomes/cm$^3$, et à ajouter de l'indium dans une proportion d'environ 0,5 mol % à environ 8 mol % par rapport aux éléments du groupe III se trouvant dans ledit matériau semiconducteur.

2. Procédé selon la revendication 1, caractérisé en ce que ladite opération d'addition de béryllium et ladite opération d'addition d'indium sont effectuées pendant ladite opération de croissance de la couche épitaxiale (16,37,49).

3.  Procédé selon la revendication 2, caractérisé en ce que ladite opération d'addition de béryllium et ladite opération d'addition d'indium sont effectuées simultanément.

4.  Procédé selon la revendication 1, caractérisé en ce que ladite opération de croissance de la couche épitaxiale (16, 37, 49) est faite à une température comprise entre environ 550°C et environ 680°C.

5.  Procédé selon la revendication 4, caractérisé en ce que ladite opération de croissance de la couche épitaxiale (16, 37, 49) est faite à une température égale ou supérieure à environ 600°C.

6.  Procédé de fabrication d'un transistor bipolaire, comprenant les opérations consistant à faire croître épitaxialement une couche de collecteur de type n (14, 47) sur une couche cristalline sous-jacente (11-13, 41-45), à faire croître épitaxialement une couche de base (16, 49) d'un matériau semiconducteur composé des groupes III-V choisi dans le groupe de matériaux comprenant l'arséniure de gallium et d'aluminium et l'arséniure d'indium, de gallium et d'aluminium sur la couche de collecteur de type n, caractérisé en ce qu'il comprend les opérations consistant à doper la couche de base suivant le type p par addition de béryllium à la couche de base avec un niveau de concentration d'environ $5 \times 10^{19}$ atomes/cm$^3$ à environ $5 \times 10^{20}$ atomes/cm$^3$, à ajouter de l'indium à la couche de base dans une proportion d'environ 0,5 mol % à environ 8 mol % par rapport aux éléments du groupe III contenus dans la couche de base, et à faire croître une couche d'émetteur de type n (20, 51-55) sur ladite couche de base.

7.  Procédé selon la revendication 6, caractérisé en ce que ladite opération de dopage et ladite opération d'addition d'indium sont effectuées pendant ladite opération de croissance de la couche de base.

8.  Procédé selon la revendication 7, caractérisé en ce que ladite opération de dopage et ladite opération d'addition d'indium sont effectuées simultanément.

9.  Procédé selon la revendication 6, caractérisé en ce que ladite croissance de la couche de base (16, 49) est faite à une température comprise entre environ 550°C et environ 680°C.

10.  Procédé selon la revendication 6, caractérisé en ce que ladite croissance de la couche de base (16, 49) s'effectue à une température d'environ 600°C ou plus.

11.  Procédé selon la revendication 6, caractérisé en ce que ladite opération de croissance de la couche de base (16, 49) comprend en outre l'opération consistant à produire une variation graduelle de la teneur en aluminium de la couche de base de façon que la teneur en aluminium augmente continûment, d'un premier côté de la couche de base, en contact avec la couche de collecteur (13, 47), à un deuxième côté de la couche de base, en contact avec la couche d'émetteur (20, 51-55).

12.  Procédé selon la revendication 6, caractérisé en ce que ladite opération de croissance de la couche d'émetteur comprend en outre l'opération consistant à produire une variation de composition graduelle de la teneur en aluminium de la couche d'émetteur, de façon que la teneur en aluminium augmente continûment, reste constante, puis diminue continûment, d'un premier côté de la couche d'émetteur (20, 51-55), en contact avec la couche de base (16, 49), à un deuxième côté, opposé audit premier côté.

13.  Procédé de fabrication d'un dispositif à semiconducteur comprenant une couche épitaxiale (16, 37, 49) d'un matériau semiconducteur des groupes III-V disposée sur une couche cristalline sous-jacente (11-14, 31-36, 41-47) en appariement de réseau avec celle-ci, ledit matériau semiconducteur étant dopé suivant le type p par addition de béryllium et étant choisi dans le groupe comprenant l'arséniure de gallium et d'aluminium et l'arséniure d'indium, de gallium et d'aluminium, comprenant l'opération consistant à faire croître ladite couche épitaxiale sur la couche cristalline sous-jacente, caractérisé par les opérations supplémentaires consistant à ajouter du béryllium avec un niveau de concentration prédéterminé, et à ajouter de l'indium dans une proportion généralement égale à celle du béryllium.

(A)

2     4     2     4

Ga (Aℓ)     As     Ga (Aℓ)     As

(B)

1     4     3     4

Be     As     In     As

# FIG. 1

# FIG. 6

FIG. 2

FIG.3

**FIG. 4**

FIG. 4

Be 7 x 10$^{19}$ cm$^{-3}$

Be 3 x 10$^{19}$ cm$^{-3}$

InAs mole fraction (%)

FIG. 5

FIG. 7

FIG. 8